# EUROPEAN PATENT SPECIFICATION

(11) **EP 0 503 200 B1**
(45) Date of publication and mention of the grant of the patent: **16.04.1997**
(21) Application number: 91311833.7
(22) Date of filing: 19.12.1991
(51) Int. Cl.: H01L 23/66, H01L 23/552

(54) **Package for microwave integrated circuit**
Packung für integrierte Mikrowellen-Schaltung
Empaquetage pour circuit intégré à micro-ondes

(30) Priority: 07.02.1991 JP 39518/91
(43) Date of publication of application: 16.09.1992
(73) Proprietor: MITSUBISHI DENKI KABUSHIKI KAISHA, Tokyo (JP)
(72) Inventor: Katoh, Takayuki, c/o Mitsubishi Denki K.K., 1 Mizuhara 4-chome, Itami-shi, Hyogo-ken (JP)
(74) Representative: Beresford, Keith Denis Lewis

(56) References cited:
- EP-A- 0 249 378
- EP-A- 0 309 942
- EP-A- 0 396 152
- EP-A- 0 408 228
- EP-A- 0 444 820
- WO-A-84/01470
- GB-A- 2 238 911
- US-A- 4 890 155
- PATENT ABSTRACTS OF JAPAN vol. 10, no. 82 (E-392)(2139) 2 April 1986 & JP-A-60 227 448
- PATENT ABSTRACTS OF JAPAN vol. 10, no. 117 (E-400)(2174) 2 May 1986& JP-A-60 251 649

## Description

The present invention relates to a package for a semiconductor device operating at high frequency of more than several tens MHz and, more particularly, to a package for a microwave integrated circuit (hereinafter referred to as IC) in which an intermediate-layer grounding metal is provided on the same plane as that on which a transmission line is provided and an upper-layer grounding metal, the intermediate-layer grounding metal, and a lower-layer grounding metal are connected with one another via through holes.

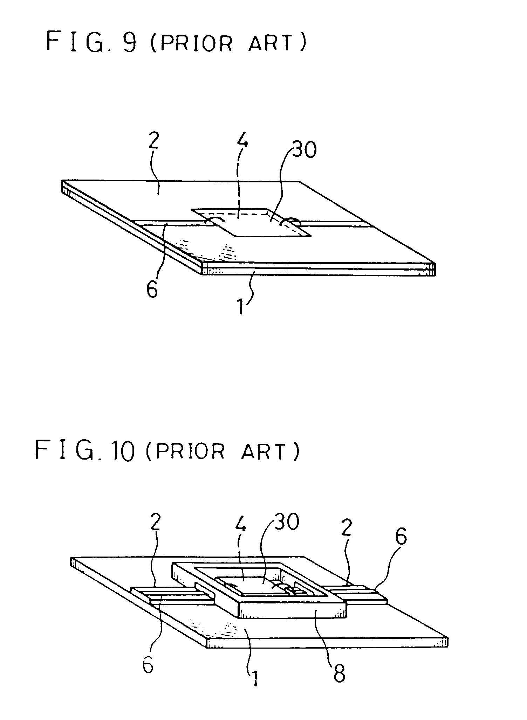

Figures 9(a) and 9(b) are perspective views illustrating a prior art micro-strip type chip carrier. In these figures, reference numeral 1 designates a grounding metal base comprising such as copper-tungsten. A dielectric layer 2 comprising ceramic is provided on the grounding metal base 1. A transmission line 6 is provided on the surface of the dielectric layer 2. The dielectric layer 2 insulates the transmission line 6 from the grounding metal base 1. The dielectric layer 2 has an aperture in the center thereof, in which an IC chip bonding part 4 for bonding a microwave IC chip 30 is provided. The rear surface of the IC chip bonding part 4 is connected to the grounding metal base 1.

The IC chip 30 is fixed on the IC chip bonding part 4 by solder or adhesive. An electric signal is transmitted through the transmission line 6 to the IC chip 30. Although this package has an advantage in that the parasitic capacitance and parasitic inductance are shielded, it has a disadvantage in that airtightness is poor because it cannot be hermetically sealed due to its configuration. In addition, the IC chip 30 and wires are exposed and this package has, in particular, no durability against the mechanical breakage. Therefore, it cannot be used in applications which requires reliability of the package. The frequency range capable of being used is approximately up to 30 GHz.

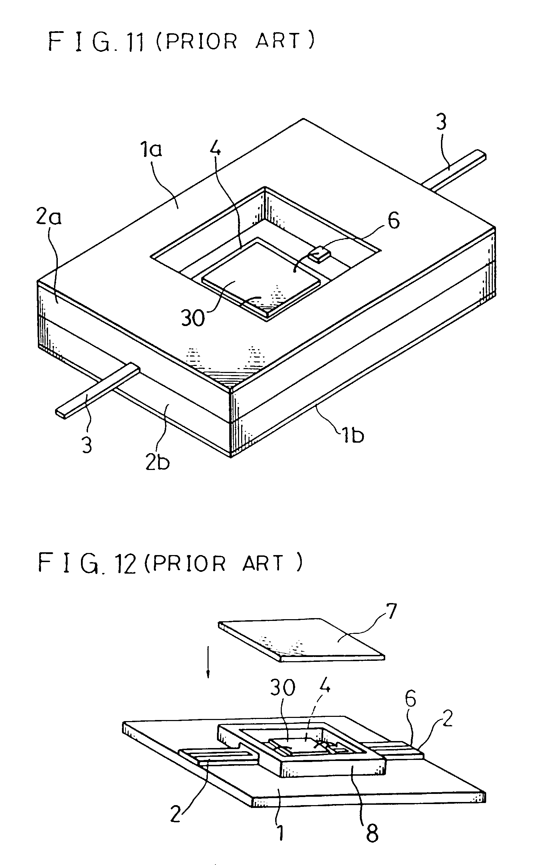

Figure 10 is a perspective view illustrating a structure of a prior art dielectric material feed-through type metal package. Figure 12 is a perspective view illustrating the package of figure 10 which is hermetically sealed. In figures 10 and 12, reference numeral 1 designates a grounding metal base. A transmission line 6 is provided on the grounding metal base 1. This transmission line 6 is insulated from the grounding metal base 1 by a ceramic dielectric material layer 2. An IC chip bonding part 4 for bonding an IC chip 30 is provided in the aperture formed in the center of the grounding metal base 1, and a ring metal cavity 8 is provided surrounding the IC chip 30.

The IC chip 30 is fixed on the IC chip bonding part 4 by solder or adhesive. An electric signal is transmitted through the transmission line 6 to the chip 30. As shown in figure 12, a metal lid 7 is put on the cavity 8, protecting the IC chip 30 and securing the airtightness. This package has advantages of high airtightness, good shielding property, and enhanced high frequency characteristic, so that it can be used at up to 20 GHz. However, it has a disadvantage in that the production cost is extremely high.

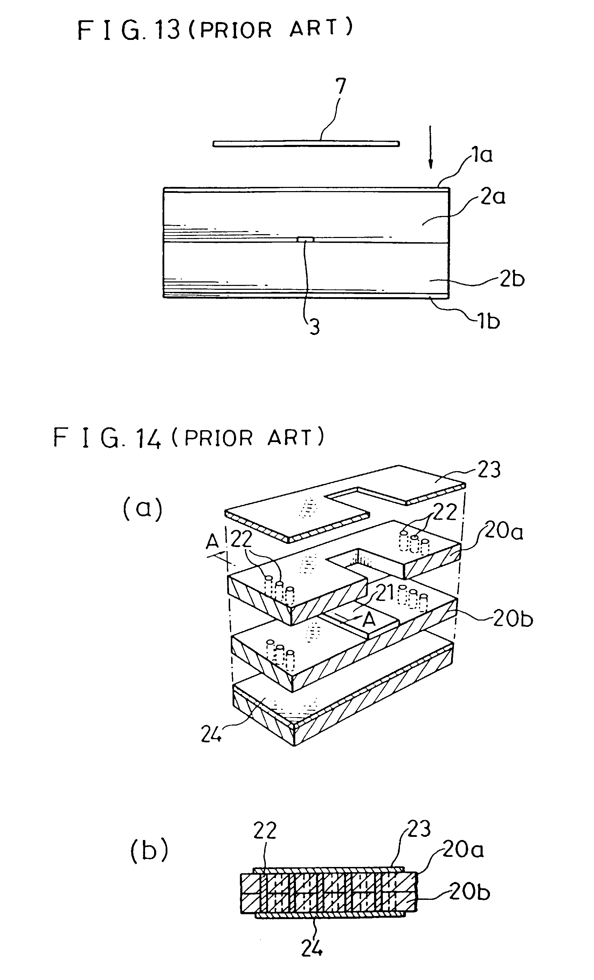

Figure 11 is a perspective view illustrating a structure of a prior art tri-plate type multi-layer ceramic package. Figure 13 is a side view illustrating the package of figure 11 which is hermetically sealed. In figures 11 and 13, a lower-side dielectric layer 2b is provided on a lower-layer grounding metal 1b and an upper-layer grounding metal 1a is provided on an upper-side dielectric layer 2a. A transmission line 6 is provided on the junction surface between the lower-side dielectric layer 2b and the upper-side dielectric layer 2a. An IC chip bonding part 4 for fixing an IC chip 30 is provided in the aperture formed in the center of the upper-layer grounding metal 1a and the upper-side dielectric layer 2a. The IC chip bonding part 4 is connected to the lower-layer grounding metal 1b to be grounded via a through hole.

The IC chip 30 is fixed on the IC chip bonding part 4 by solder or adhesive. Then, as shown in figure 13, a metal lid 7 is put on the package, protecting the IC chip 30 and securing the airtightness. This package has a merit of low production cost, approximately 1000 yen per one. However, since the upper-layer grounding metal 1a and the lower-layer grounding metal 1b are not directly in contact with each other, when metal is plated on the side surface of the package to connect the two grounding metals 1a and 1b, the perimeter of the metal layer surrounding the transmission line 6 in the cross section vertical to the transmission line 6 is so long that the inductance component increases, deteriorating the shielding characteristic and the high frequency characteristic. Therefore, this package is used only at up to several GHz.

Meanwhile, a prior art package having a pseud coaxial line configuration is disclosed in the Japanese Published Patent Application No.1-135102. Figure 14(a) is an exploded view illustrating a structure of this prior art package. Figure 14(b) is a cross-sectional view taken along a line A - A in figure 14(a). In figures 14(a) and 14(b), a ceramic layer 20b is provided on a lower-layer grounding metal 24 and a signal conductor 21 is provided in the center of the surface of the ceramic layer 20b. Then, a ceramic layer 20a having a cut-off portion for exposing the signal conductor 21 is provided on the ceramic layer 20b. A plurality of cylindrical through holes 22 are provided penetrating the ceramic layers 20a and 20b. The through holes 22 are those for electrically conducting the upper surface of the ceramic layers with the lower surfaces of the ceramic layers. An upper-layer grounding plate 23 is provided on the ceramic layer 20a. The upper-layer grounding metal 23 and the lower-layer grounding metal 24 are connected to each other via the through holes 22 thereby to shield the signal conductor 21.

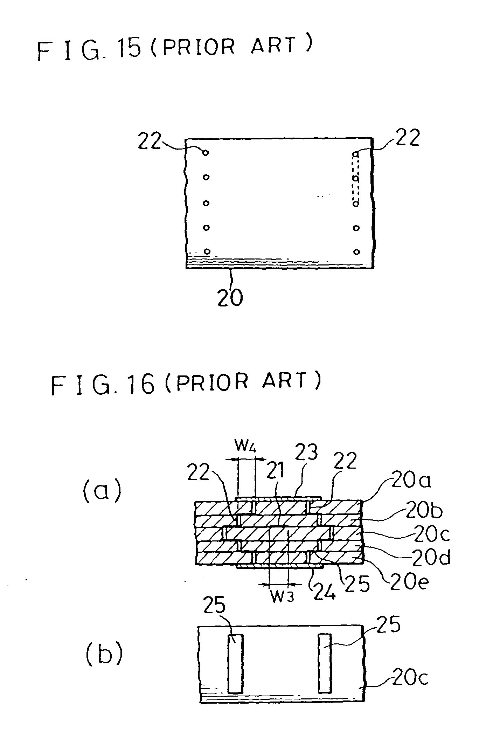

Figure 15 is a plan view illustrating a structure of an alternative of the package shown in figure 14. In this structure, the cylindrical through holes 22 are provided closely to each other, resulting in an enhancement of the shielding characteristic.

Figure 16(a) is a cross-sectional side view illustrating a structure of another alternative of the package shown in figure 14. Figure 16(b) is a plan view illustrating a ceramic layer 20c of the package shown in figure 16(a). In figures 16(a) and 16(b), a plurality of cylindrical through holes 22 are produced penetrating the ceramic layers 20a to 20e and arranged at slightly different positions to produce a pseudo coaxial configuration, and the upper surface of a through hole (22) conductor and the lower surface of another through hole (22) conductor are electrically connected by a metal plate 25 which is provided therebetween.

The prior art microwave IC packages constructed as described above have the following drawbacks.

Since the micro-strip type chip carrier shown in figure 9 cannot be sealed up due to its construction, no good airtightness is obtained. In addition, since the chip and the wire of the package are exposed, the package has no durability against mechanical breakage. Therefore, it is impossible to use the package of figure 9 for applications which require reliability.

The dielectric feed-through type metal package shown in figure 10 has a good shielding characteristic and a high-frequency characteristic, but the production cost thereof is extremely high.

In the tri-plate type multiple layer ceramic package shown in figure 11, when the upper-layer and lower-layer metal plates are connected using metals plated on the side surfaces or external surfaces of the package, the inductance component may be increased due to its length, deteriorating the shielding characteristic and the high-frequency characteristic.

The package shown in figures 14 and 15 is shielded by the through holes, but the shielding in the horizontal direction to the signal line is not sufficient.

Furthermore, it is difficult to form the package of figure 16(a)in a pseudo-coaxial configuration by shifting the through holes and a simulation is required therefor. Since the width W₃ of signal line is almost equal to the width W₄ of the metal plate, leakage of the electric line of force increases, resulting in a transmission loss and a deterioration of voltage standing wave ratio caused by generation of higher transmission mode.

The present invention is directed to solving the above described problems and has for its object to provide an IC package which has a good shielding characteristic and a high frequency characteristic and can be produced at low cost.

Other advantages of the present invention will become apparent from the detailed description given hereinafter; it should be understood, however, that the detailed description and specific embodiment are given by way of illustration only, since various changes and modifications within the the scope of the appended claims will become apparent to those skilled in the art from this detailed description.

According to the present invention as set out in claim 1, a microwave IC package comprises a first intermediate-layer grounding metal and a transmission line which are produced on the same plane to form a co-planar type line, an upper-layer grounding metal and a lower-layer grounding metal which are provided above and below the intermediate-layer grounding metal to form a tri-plate type line, and through holes provided for connecting all the grounding metals. Therefore, the transmission line is shielded in the vicinity thereof in the horizontal direction to the transmission line, whereby the perimeter of the shielding metal in the cross section vertical to the transmission line is shortened. As a result, the inductance component is suppressed.

According to a particular feature of the present invention, the width of the intermediate-layer grounding metal is three to five times that of the transmission line. Therefore, a leakage of the electric line of force can be reduced and the high frequency characteristic can be improved.

According to one embodiment of the present invention, a second intermediate-layer grounding metal is provided at at least one position between the upper-layer grounding metal and the first intermediate-layer grounding metal or between the first intermediate-layer grounding metal and the lower-layer grounding metal, and all the grounding metals are connected to one another via the through holes. Thereby the shielding characteristic and the high frequency characteristic of the package can be further improved.

It is noted that US-A-4890155 discloses an ultra-high frequency chip package which uses conductive through holes and intermediate layers for impedance adjustment to improve insulating performance between adjacent signal lines. It is also noted that EP-A-0396152 discloses a package for a chip operating at frequencies up to 1 GHz, in which groundlines are formed on either side of signal lines, so as to form co-planar waveguides.

### BRIEF DESCRIPTION OF THE DRAWINGS

Figure 1 is a perspective view illustrating a structure of a microwave IC package comprising an intermediate-layer grounding metal in accordance with a first embodiment of the present invention;
Figure 2 is a plan view illustrating the microwave IC package of figure 1;
Figure 3 is a side view illustrating the microwave IC package of figure 1;
Figure 4 is a side view illustrating the microwave IC package of figure 1 which is hermetically sealed;
Figure 5 is a side view illustrating a microwave IC package comprising a plurality of intermediate-layer grounding metals, which is hermetically sealed, in accordance with a second embodiment of the present invention;
Figures 6(a) to 6(f) are perspective views illustrating structures of respective layers of the microwave IC package of figure 5;
Figure 7 is a side view illustrating a cross section of the microwave IC package of figure 1 on which an IC chip is mounted;
Figure 8 is a plan view illustrating a cross section of the microwave IC package of figure 1 on which an IC chip is mounted;
Figure 9 is a perspective view illustrating a structure of a prior art micro-strip type chip carrier;
Figure 10 is a perspective view illustrating a structure of a prior art dielectric feed-through type metal package;
Figure 11 is a perspective view illustrating a structure of a prior art tri-plate type multiple layer ceramic package;
Figure 12 is a perspective view illustrating the prior art dielectric feed-through type metal package of figure 10 which is hermetically sealed;
Figure 13 is a side view illustrating the prior art tri-plate type multiple layer ceramic package of figure 11 which is hermetically sealed;
Figure 14(a) is an exploded view illustrating a structure of a prior art ceramic package using through holes and Figure 14(b) is a cross-sectional view thereof;
Figure 15 is a plan view illustrating a structure of a prior art ceramic package in which through holes are provided closely to each other; and
Figure 16(a) is a cross sectional view illustrating a structure of a prior art ceramic package in which through holes are provided at slightly different positions and Figure 16(b) is a plan view thereof.

### DETAILED DESCRIPTION OF THE PREFERRED EMBODIMENT

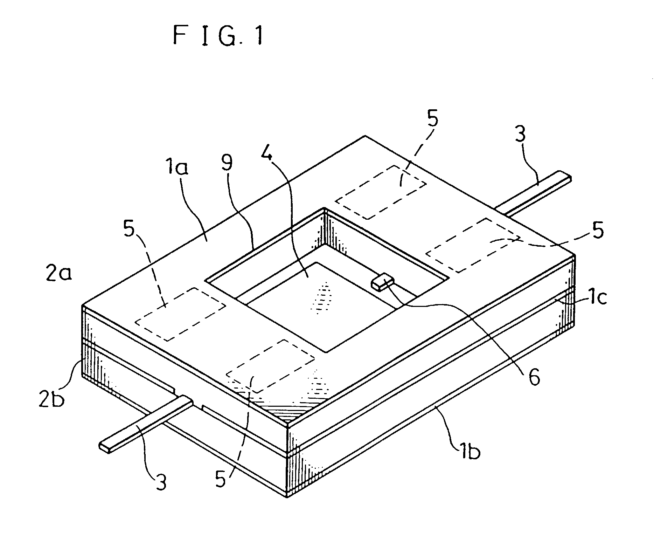

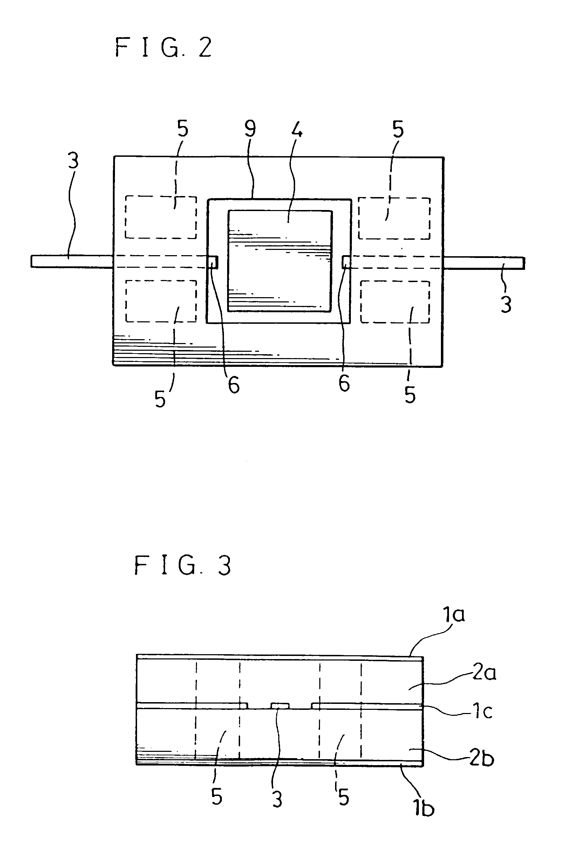

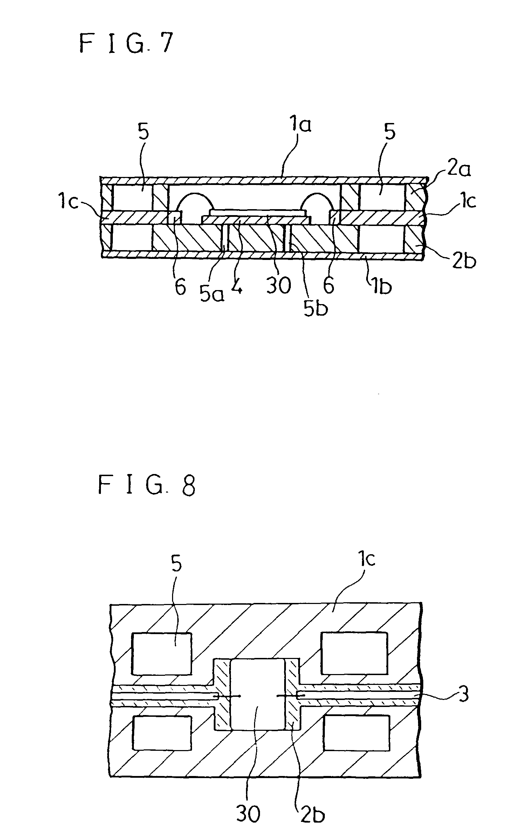

Figure 1 is a perspective view illustrating a structure of a microwave IC tri-plate type multi-layer ceramic package in accordance with a first embodiment of the present invention. Figure 2 is a plan view of the microwave IC tri-plate type multi-layer ceramic package of figure 1 and figure 3 is a side view thereof. Figure 7 is a side view illustrating a cross section of the microwave IC tri-plate type multi-layer ceramic package of figure 1 on which an IC chip 30 is mounted. Figure 8 is a plan view illustrating a cross-section of the microwave IC package of figure 1 on which the IC chip 30 is mounted. In figures 1, 2, 3, 7 and 8, a lower dielectric layer 2b is provided on a lower-layer grounding metal 1b. A transmission line 6 which inputs and outputs signals to the IC chip 30 is provided on the lower dielectric layer 2b. An intermediate-layer grounding metal 1c is provided on the same plane as that on which the transmission line 6 is provided, thereby forming a co-planar type line. Furthermore, an upper dielectric layer 2a and an upper-layer grounding metal 1a are produced on the intermediate-layer grounding metal 1c, thereby forming a tri-plate type line. Ordinarily, gold (electrolytic plating), tungsten simple, gold-plated tungsten or the like is used as the grounding metal. An IC chip bonding part 4 is provided in the aperture 9 formed in the center of the upper dielectric layer 2a and the upper-layer grounding metal 1a. In some cases, a metal film is plated on the side walls of the aperture 9 to shield the IC chip 30 in accordance with the performance to be pursued or the production cost of the device. The IC chip bonding part 4 is connected to the lower-layer grounding metal 1b via through holes 5a. The IC chip bonding part 4 comprises material such as gold-plated titanium or gold-plated AlN (aluminum nitride). The upper-layer, intermediate-layer, and lower-layer grounding metals 1a, 1c, and 1b are electrically connected to one another via the through holes 5. The IC chip 30 is shielded by the through holes 5 surrounding the chip. Furthermore, the rear surface of the IC chip bonding part 4 is connected to the lower-layer grounding metal 1b via the through holes 5a.

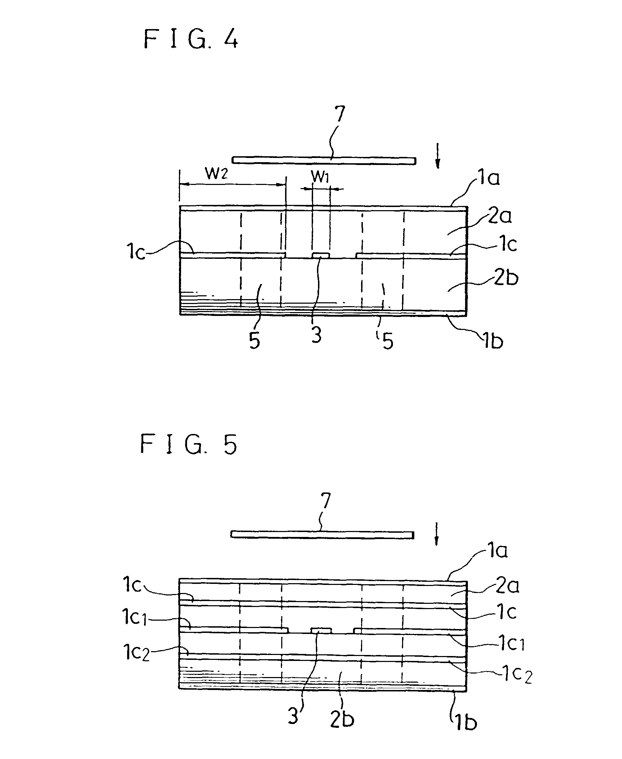

As shown in figure 7, the IC chip 30 is bonded on the IC chip bonding part 4 using solder, adhesive or the like, and then the transmission line 6, which is insulated, is produced on the dielectric layer 2 comprising ceramic. A metal lid 7 is put on the package, as shown in figure 4, to protect the IC chip 30 and to keep the airtightness.

In the above-described first embodiment, the intermediate-layer grounding metal 1c and the transmission line 6 form the co-planar type line, and the upper-layer, intermediate-layer, and lower-layer grounding metals 1a, 1c, and 1b form the tri-plate type line, and these three grounding metals are connected to one another via the through holes. Therefore, the perimeter of the shielding metal surrounding the transmission line 6 in the cross-section vertical to the transmission line 6 is shortened and the vicinity of the transmission line 6 is shielded by the through holes 5 in the horizontal direction to the transmission line 6, resulting in large improvements in the shielding characteristic and the high frequency characteristic. The package having such structure can be practically used at 18 to 30 GHz. In addition, this package can be easily produced because of its simple structure, low production cost, and low material cost.

The package in accordance with the first embodiment has the following aspects and advantages as compared with the prior art IC package shown in figure 16. That is, in this embodiment, a plurality of through holes 5 are produced at the both sides of the transmission line 6 to form the pseudo-coaxial line configuration similarly as in the prior art device of figure 16 and further the through holes 5 are provided closer to the transmission line 6 than that of the prior art device, thereby improving the shielding characteristic and the high frequency characteristic. Furthermore, as shown in figure 4, the width of the metal layer connecting between through holes, that is, the width W₂ of the intermediate-layer grounding metal is three to five times the width W₁ of the transmission line 6, whereby a leakage of the electric line of force can be reduced and the transmission loss and the deterioration of voltage standing wave ratio, which are caused by a high transmission mode, can be prevented. Furthermore, the IC chip 30 can be easily sealed up using this package as shown in figure 4. Consequently, the IC package having good shielding characteristic and high-frequency characteristic can be obtained at low production cost.

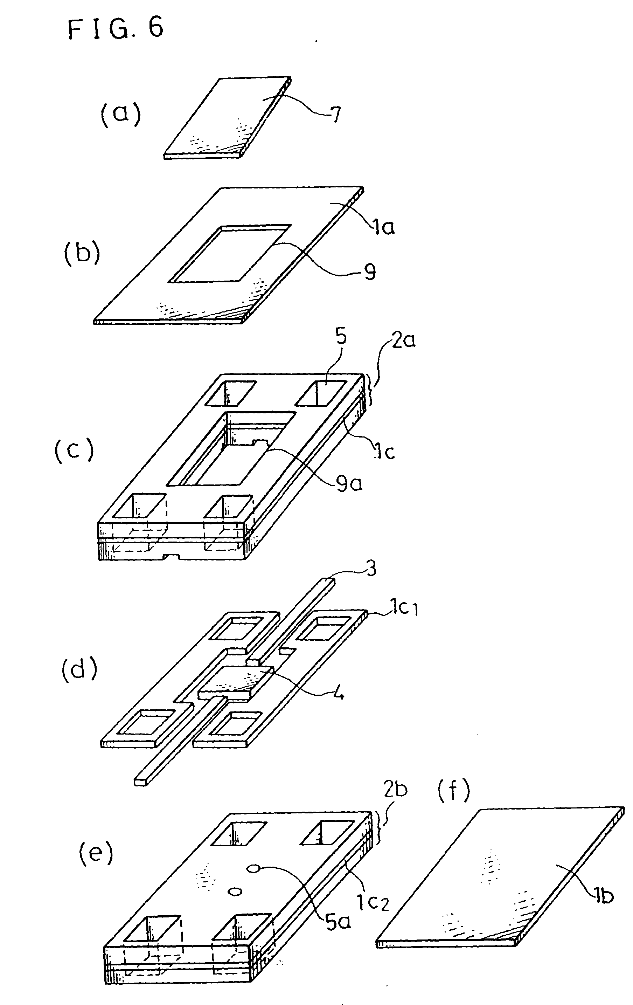

Figure 5 is a cross-sectional view showing a tri-plate type multi-layer ceramic package in which an IC chip 30 is sealed up in accordance with a second embodiment of the present invention. Figures 6(a) to 6(f) are perspective views showing structures of respective layers of the tri-plate type multi-layer ceramic package of figure 5. In figures 5 and 6, reference characters 1c₁ and 1c₂ designate intermediate-layer grounding metals.

In this second embodiment, a plurality of intermediate-layer grounding metals 1c to 1c₂ are produced, whereby the package has a large number of grounding surfaces than the package of the first embodiment, enhancing the shielding characteristic and the high frequency characteristic.

While in the above-described second embodiment a two-port package is described, the present invention may be applied to a three-port or more-port type package with the same effects as described above.

While in the above-described embodiments ceramic is used as the dielectric layer 2, LFM (low temperature firing material including glass), AlN (aluminum nitride), or PTFE (porous Teflon) can be used as the material therefor.

As is evident from the foregoing description, according to the present invention, a microwave IC package comprises a first intermediate-layer grounding metal and a transmission line produced on the same surface to form a co-planar type line, an upper and a lower-layer grounding metals which are provided above and below the first intermediate-layer grounding metal to form a tri-plate type line, and through holes for connecting all the three grounding metals. Therefore, the transmission line is shielded in the vicinity thereof in the direction horizontal to the transmission line, and further, the perimeter of the shielding metal in the cross section vertical to the transmission line is shortened. As a result, inductance component is suppressed.

In addition, since the width of the intermediate-layer grounding metal is three to five times that of the transmission line, the leakage of the electric line of force is reduced, whereby the shielding characteristic and the high frequency characteristic are improved. As well, the package can be produced at a low production cost.

In addition, a second intermediate-layer grounding metal is produced at least one of positions between the upper and the first intermediate-layer grounding metals and between the first intermediate-layer and the lower-layer grounding metals and the all grounding metals are connected to one another via through holes. Therefore, the shielding characteristic can be further improved with the effects described above.

## Claims

1. A package for a microwave integrated circuit, comprising:
a first dielectric material layer (2b) on the surface of which a transmission line (6) for inputting or outputting a signal of said microwave integrated circuit is arranged;
a second dielectric material layer (2a) laminated on said first dielectric layer having an aperture (9) in which an IC chip bonding part (4) is provided;
a first grounding metal layer (1b) produced on the entire rear surface of said first dielectric layer;
a second ground metal layer (la) produced on said second dielectric layer; and
a first intermediate-layer grounding metal (lc) produced on the same plane as that on which said transmission line is produced, forming a co-planar type line with said transmission line, with through holes (5) electrically connecting said intermediate-layer grounding metal with said first and second grounding metals, the width of said intermediate-layer grounding metal between through holes at one side of the transmission line being three to five times that of said transmission line, in a direction transverse to the transmission line.

2. A package for a microwave integrated circuit in accordance with claim 1 wherein said grounding metal layer (lc) comprises gold, formed for example by electrolytic plating, tungsten, or gold-plated tungsten.

3. A package for a microwave integrated circuit in accordance with claim 1 or 2 wherein said first dielectric layer (2b) comprises ceramic, low temperature firing glass, aluminum nitride, or porous Teflon.

4. A package for a microwave integrated circuit in accordance with claim 1, 2 or 3 wherein an IC chip bonding part (4) for bonding said microwave integrated circuit thereon comprises gold-plated titanium or gold-plated aluminum nitride.

5. A package for a microwave integrated circuit in accordance with claim 1, 2, 3 or 4 wherein a metal film is plated on the side wall of the central aperture of said upper dielectric layer and said upper-layer grounding metal thereby to shield the IC chip.

6. A package for a microwave integrated circuit in accordance with any claim which provides substantial shielding of signals at 18 to 30 GHz.

7. A package for a microwave integrated circuit in accordance with any preceding claim wherein through holes are arranged on both sides of and close to said transmission line so as to form a pseudo coaxial line configuration.

8. A package for a microwave integrated circuit in accordance with any preceding claim further comprising:
a second intermediate-layer grounding metal (1c, 1c2) formed at one or more positions between said first grounding metal layer and said first intermediate-layer grounding metal (1c1) and/or between said second grounding metal layer and said first intermediate-layer grounding metal; and
through holes electrically connecting these metal layers with each other.

## Patentansprüche

1. Packung für eine integrierte Mikrowellenschaltung mit:
einer ersten dielektrischen Materialschicht (2b) an der Oberfläche, an der eine Übertragungsleitung (6) zum Ein- und Ausgang eines Signals der integrierten Mikrowellenschaltung angeordnet ist;
einer zweiten dielektrischen Materialschicht (2a), die auf die erste dielektrische Schicht laminiert ist und eine Öffnung (9) aufweist, in der ein IC-Chip-Sockel-element bzw. -Bondteil (4) vorgesehen ist;
einer ersten an Masse gelegten Metallschicht (1b), die an der gesamten rückseitigen Oberfläche der ersten dielektrischen Schicht aufgebracht wird;
einer zweiten an Masse gelegten Metallschicht (1a), die an der zweiten dielektrischen Schicht aufgebracht wird; und
einem ersten an Masse gelegten Zwischenschichtmetall (1c), das auf der gleichen Ebene wie die Übertragungsleitung aufgebracht wird, die eine koplanar-artige Leitung mit der Übertragungsleitung mit Durchgangsöffnungen (5) formt, die das an Masse gelegte Zwischenschichtmetall mit dem ersten und zweiten an Masse gelegten Metall elektrisch verbindet, wobei die Breite des an Masse gelegten Zwischenschichtmetalls zwischen den Durchgangsöffnungen auf der einen Seite der Übertragungsleitung drei bis fünf mal die Breite der Übertragungsleitung in transversaler Richtung zur Übertragungsleitung ist.

2. Packung für integrierte Mikrowellenschaltung nach Anspruch 1, dadurch gekennzeichnet, daß die an Masse gelegte Metallschicht (1c) Gold, das beispielsweise durch elektrolytische Plattierung bzw. Beschichten ausgebildet wird, Wolfram oder Gold plattiertes bzw. beschichtetes Wolfram enthält.

3. Packung für integrierte Mikrowellenschaltung nach Anspruch 1 oder 2, dadurch gekennzeichnet, daß die erste dielektrische Schicht (2b) Keramik, Niedertemperatur-Befeuerungsglas bzw. -Auslösungsglas, Aluminiumnitride oder poröses Teflon enthält.

4. Packung für integrierte Mikrowellenschaltung nach Anspruch 1, 2 oder 3, dadurch gekennzeichnet, daß ein IC-Chip-Sockelelement (4), zur Verbindung bzw. zum Bonden der integrierten Mikrowellenschaltung darauf, Gold plattiertes bzw. beschichtetes Titan oder Gold plattiertes bzw. beschichtetes Aluminiumnitrid enthält.

5. Packung für integrierte Mikrowellenschaltung nach Anspruch 1, 2, 3 oder 4, dadurch gekennzeichnet, daß ein Metallfilm auf die Seitenwand der zentralen Öffnung der oberen dielektrischen Schicht und des an Masse gelegten Oberschichtmetalls plattiert bzw. beschichtet wird, um dadurch den IC-Chip abzuschirmen.

6. Packung für integrierte Mikrowellenschaltung nach einem der vorhergehenden Ansprüche, dadurch gekennzeichnet, daß sie für eine wesentliche Abschirmung von Signalen von 18 bis 30 GHz sorgt.

7. Packung für integrierte Mikrowellenschaltung nach einem der vorhergehenden Ansprüche, dadurch gekennzeichnet, daß die Durchgangsöffnungen an beiden Seiten und nahe der Übertragungsleitung angeordnet sind, so daß sie eine pseudo-koaxiale Leitungskonfiguration bilden.

8. Packung für integrierte Mikrowellenschaltung nach einem der vorhergehenden Ansprüche, dadurch gekennzeichnet, daß sie weiterhin enthalten:
ein zweites an Masse gelegtes Zwischenschichtmetall (1c, 1c2), das an einer oder mehreren Positionen zwischen der ersten an Masse gelegten Metallschicht und dem ersten an Masse gelegten Zwischenschichtmetall (1c1) und/oder zwischen der zweiten an Masse gelegten Metallschicht und dem ersten an Masse gelegten Zwischenschichtmetall ausgebildet ist; und
Durchgangsöffnungen, die diese Metallschichten elektrisch miteinander verbinden.

## Revendications

1. Boîtier pour un circuit intégré à micro-ondes, comprenant :
une première couche de matériau diélectrique (2b) sur la surface de laquelle est agencée une ligne de transmission (6) pour recevoir ou produire un signal dudit circuit intégré à micro-ondes ;
une seconde couche de matériau diélectrique (2a) laminée sur ladite première couche diélectrique ayant une ouverture (9) dans laquelle une partie de liaison de pastille à circuit intégré (4) est prévue ;
une première couche de métal de masse (1b) produite sur toute la surface arrière de ladite première couche diélectrique ;
une seconde couche de métal de masse (1a) produite sur ladite seconde couche diélectrique ; et
un premier métal de masse de couche intermédiaire (1c) produit sur le même plan que celui sur lequel ladite ligne de transmission est produite, formant une ligne du type coplanaire avec ladite ligne de transmission, avec des trous traversants (5) reliant électriquement ledit métal de masse de couche intermédiaire auxdits premier et second métaux de masse, la largeur dudit métal de masse de couche intermédiaire entre trous traversants à un côté de la ligne de transmission étant de trois à cinq fois celle de la ligne de transmission, dans une direction transversale à la ligne de transmission.

2. Boîtier pour un circuit intégré à micro-ondes selon la revendication 1 dans lequel la couche de métal de masse précitée (1c) comprend de l'or, formé par exemple par placage électrolytique, du tungstène ou du tungstène plaqué d'or.

3. Boîtier pour un circuit intégré à micro-ondes selon la revendication 1 ou 2 dans lequel la première couche diélectrique précitée (2b) comprend de la céramique, du verre à faible température de combustion, du nitrure d'aluminium ou du Teflon poreux.

4. Boîtier pour un circuit intégré à micro-ondes selon la revendication 1, 2 ou 3 dans lequel une partie de liaison de pastille à circuit intégré (4) pour lier ledit circuit intégré à micro-ondes sur celui-ci comprend du titane plaqué d'or ou du nitrure d'aluminium plaqué d'or.

5. Boîtier pour un circuit intégré à micro-ondes selon la revendication 1, 2, 3 ou 4 dans lequel un film de métal est plaqué sur la paroi latérale de l'ouverture centrale de la couche diélectrique supérieure précitée et le métal de masse de couche supérieure précité, pour blinder de la sorte la pastille à circuit intégré.

6. Boîtier pour un circuit intégré à micro-ondes selon l'une quelconque des revendications précédentes qui produit un blindage substantiel de signaux de 18 à 30 GHz.

7. Boîtier pour un circuit intégré à micro-ondes selon l'une quelconque des revendications précédentes dans lequel des trous traversants sont agencés sur les deux côtés et à proximité de la ligne de transmission précitée afin de former une configuration de ligne pseudo coaxiale.

8. Boîtier pour un circuit intégré à micro-ondes selon l'une quelconque des revendications précédentes comprenant de plus :
un second métal de masse de couche intermédiaire (1c, 1c2) formé à une ou plusieurs positions entre la première couche de métal de masse précitée et le premier métal de masse de couche intermédiaire précité (1c1) et/ou entre la seconde couche de métal de masse précitée et le premier métal de masse de couche intermédiaire précité ; et
des trous traversants reliant électriquement ces couches de métal les unes avec les autres.
